# EUROPEAN PATENT APPLICATION

(11) **EP 4 102 552 A1**
(43) Date of publication of application: **14.12.2022**
(21) Application number: 22169622.2
(22) Date of filing: 25.04.2022
(51) Int. Cl.: H01L 21/768

(54) **NARROW CONDUCTIVE STRUCTURES FOR GATE CONTACT OR TRENCH CONTACT**

(30) Priority: 07.06.2021 US 202117340747
(71) Applicant: INTEL Corporation, Santa Clara, CA 95054 (US)
(72) Inventor: GULER, Leonard, Hillsboro, 97124 (US); HARAN, Mohit, Hillsboro, 97124 (US); GHANI, Tahir, Portland, 97229 (US); WALLACE, Charles, Portland, 97212 (US)
(74) Representative: Goddar, Heinz J.

(57) **Abstract**

Narrow conductive via structures for gate contact or trench contact are described. In an example, an integrated circuit structure includes a plurality of gate structures above a substrate. A plurality of conductive trench contact structures is alternating with the plurality of gate structures. The integrated circuit structure also includes a plurality of dielectric spacers, a corresponding one of the plurality of dielectric spacers between adjacent ones of the plurality of gate structures and the plurality of conductive trench contact structures. A dielectric liner is along the plurality of dielectric spacers over the plurality of gate structures. A plurality of conductive pin structures is between the dielectric liner, individual ones of the plurality of conductive pin structures on corresponding ones of the plurality of gate structures.

## Description

### TECHNICAL FIELD

Embodiments of the disclosure are in the field of advanced integrated circuit structure fabrication and, in particular, narrow conductive structures for gate contact or trench contact.

### BACKGROUND

For the past several decades, the scaling of features in integrated circuits has been a driving force behind an ever-growing semiconductor industry. Scaling to smaller and smaller features enables increased densities of functional units on the limited real estate of semiconductor chips. For example, shrinking transistor size allows for the incorporation of an increased number of memory or logic devices on a chip, lending to the fabrication of products with increased capacity. The drive for ever-more capacity, however, is not without issue. The necessity to optimize the performance of each device becomes increasingly significant.

Variability in conventional and currently known fabrication processes may limit the possibility to further extend them into the 10 nanometer node or sub-10 nanometer node range. Consequently, fabrication of the functional components needed for future technology nodes may require the introduction of new methodologies or the integration of new technologies in current fabrication processes or in place of current fabrication processes.

In the manufacture of integrated circuit devices, multi-gate transistors, such as tri-gate transistors, have become more prevalent as device dimensions continue to scale down. Tri-gate transistors are generally fabricated on either bulk silicon substrates or silicon-on-insulator substrates. In some instances, bulk silicon substrates are preferred due to their lower cost and compatibility with the existing high-yielding bulk silicon substrate infrastructure.

Scaling multi-gate transistors has not been without consequence, however. As the dimensions of these fundamental building blocks of microelectronic circuitry are reduced and as the sheer number of fundamental building blocks fabricated in a given region is increased, the constraints on the semiconductor processes used to fabricate these building blocks have become overwhelming.

### BRIEF DESCRIPTION OF THE DRAWINGS

Figures 1A-1D illustrate cross-sectional views illustrating various operations in a method of fabricating narrow conductive structures for gate contact, in accordance with an embodiment of the present disclosure.
Figure 2 illustrates a cross-sectional view illustrating an integrated circuit structure including a narrow conductive structure for gate contact, in accordance with an embodiment of the present disclosure.
Figure 3A illustrates a plan view of a semiconductor device having a gate contact disposed over an inactive portion of a gate electrode.
Figure 3B illustrates a cross-sectional view of a non-planar semiconductor device having a gate contact disposed over an inactive portion of a gate electrode.
Figure 4A illustrates a plan view of a semiconductor device having a gate contact via disposed over an active portion of a gate electrode, in accordance with an embodiment of the present disclosure.
Figure 4B illustrates a cross-sectional view of a non-planar semiconductor device having a gate contact via disposed over an active portion of a gate electrode, in accordance with an embodiment of the present disclosure.
Figures 5A-5D illustrate cross-sectional views illustrating various operations in a method of fabricating narrow conductive structures for gate contact or trench contact, in accordance with an embodiment of the present disclosure.
Figure 6 illustrates a plan view and corresponding cross-sectional views of an integrated circuit structure having trench contacts and a gate contact, in accordance with an embodiment of the present disclosure.
Figure 7A illustrates a plan view of another semiconductor device having a gate contact via disposed over an active portion of a gate, in accordance with another embodiment of the present disclosure.
Figure 7B illustrates a plan view of another semiconductor device having a trench contact via coupling a pair of trench contacts, in accordance with another embodiment of the present disclosure.
Figure 8 illustrates a computing device in accordance with one implementation of the disclosure.
Figure 9 illustrates an interposer that includes one or more embodiments of the disclosure.
Figure 10 is an isometric view of a mobile computing platform employing an IC fabricated according to one or more processes described herein or including one or more features described herein, in accordance with an embodiment of the present disclosure.
Figure 11 illustrates a cross-sectional view of a flip-chip mounted die, in accordance with an embodiment of the present disclosure.

### DESCRIPTION OF THE EMBODIMENTS

Narrow conductive structures for gate contact or trench contact, and methods of fabricating narrow conductive structures for gate contact or trench contact, are described. In the following description, numerous specific details are set forth, such as specific integration and material regimes, in order to provide a thorough understanding of embodiments of the present disclosure. It will be apparent to one skilled in the art that embodiments of the present disclosure may be practiced without these specific details. In other instances, well-known features, such as integrated circuit design layouts, are not described in detail in order to not unnecessarily obscure embodiments of the present disclosure. Furthermore, it is to be appreciated that the various embodiments shown in the Figures are illustrative representations and are not necessarily drawn to scale.

The following detailed description is merely illustrative in nature and is not intended to limit the embodiments of the subject matter or the application and uses of such embodiments. As used herein, the word "exemplary" means "serving as an example, instance, or illustration." Any implementation described herein as exemplary is not necessarily to be construed as preferred or advantageous over other implementations. Furthermore, there is no intention to be bound by any expressed or implied theory presented in the preceding technical field, background, brief summary or the following detailed description.

This specification includes references to "one embodiment" or "an embodiment." The appearances of the phrases "in one embodiment" or "in an embodiment" do not necessarily refer to the same embodiment. Particular features, structures, or characteristics may be combined in any suitable manner consistent with this disclosure.

Terminology. The following paragraphs provide definitions or context for terms found in this disclosure (including the appended claims):
"Comprising." This term is open-ended. As used in the appended claims, this term does not foreclose additional structure or operations.
"Configured To." Various units or components may be described or claimed as "configured to" perform a task or tasks. In such contexts, "configured to" is used to connote structure by indicating that the units or components include structure that performs those task or tasks during operation. As such, the unit or component can be said to be configured to perform the task even when the specified unit or component is not currently operational (e.g., is not on or active). Reciting that a unit or circuit or component is "configured to" perform one or more tasks is expressly intended not to invoke 35 U.S.C. §112, sixth paragraph, for that unit or component.
"First," "Second," etc. As used herein, these terms are used as labels for nouns that they precede, and do not imply any type of ordering (e.g., spatial, temporal, logical, etc.).
"Coupled" - The following description refers to elements or nodes or features being "coupled" together. As used herein, unless expressly stated otherwise, "coupled" means that one element or node or feature is directly or indirectly joined to (or directly or indirectly communicates with) another element or node or feature, and not necessarily mechanically.

In addition, certain terminology may also be used in the following description for the purpose of reference only, and thus are not intended to be limiting. For example, terms such as "upper", "lower", "above", and "below" refer to directions in the drawings to which reference is made. Terms such as "front", "back", "rear", "side", "outboard", and "inboard" describe the orientation or location or both of portions of the component within a consistent but arbitrary frame of reference which is made clear by reference to the text and the associated drawings describing the component under discussion. Such terminology may include the words specifically mentioned above, derivatives thereof, and words of similar import.

"Inhibit" - As used herein, inhibit is used to describe a reducing or minimizing effect. When a component or feature is described as inhibiting an action, motion, or condition it may completely prevent the result or outcome or future state completely. Additionally, "inhibit" can also refer to a reduction or lessening of the outcome, performance, or effect which might otherwise occur. Accordingly, when a component, element, or feature is referred to as inhibiting a result or state, it need not completely prevent or eliminate the result or state.

Embodiments described herein may be directed to front-end-of-line (FEOL) semiconductor processing and structures. FEOL is the first portion of integrated circuit (IC) fabrication where the individual devices (e.g., transistors, capacitors, resistors, etc.) are patterned in the semiconductor substrate or layer. FEOL generally covers everything up to (but not including) the deposition of metal interconnect layers. Following the last FEOL operation, the result is typically a wafer with isolated transistors (e.g., without any wires).

Embodiments described herein may be directed to back-end-of-line (BEOL) semiconductor processing and structures. BEOL is the second portion of IC fabrication where the individual devices (e.g., transistors, capacitors, resistors, etc.) get interconnected with wiring on the wafer, e.g., the metallization layer or layers. BEOL includes contacts, insulating layers (dielectrics), metal levels, and bonding sites for chip-to-package connections. In the BEOL part of the fabrication stage contacts (pads), interconnect wires, vias and dielectric structures are formed. For modern IC processes, more than 10 metal layers may be added in the BEOL.

Embodiments described below may be applicable to FEOL processing and structures, BEOL processing and structures, or both FEOL and BEOL processing and structures. In particular, although an exemplary processing scheme may be illustrated using a FEOL processing scenario, such approaches may also be applicable to BEOL processing. Likewise, although an exemplary processing scheme may be illustrated using a BEOL processing scenario, such approaches may also be applicable to FEOL processing.

In accordance with an embodiment of the present disclosure, conductive via structures and processes are described. In accordance with an embodiment of the present disclosure, contact over active gate (COAG) structures and processes are described. One or more embodiments of the present disclosure are directed to semiconductor structures or devices having one or more gate contact structures (e.g., as gate contact vias) disposed over active portions of gate electrodes of the semiconductor structures or devices. One or more embodiments of the present disclosure are directed to methods of fabricating semiconductor structures or devices having one or more gate contact structures formed over active portions of gate electrodes of the semiconductor structures or devices. Approaches described herein may be used to reduce a standard cell area by enabling gate contact formation over active gate regions. In accordance with one or more embodiments, gate contacts or trench contacts are implemented according to processes described herein.

Embodiments may be implemented to fabricate pin gate and/or pin trench contact (TCN). It is to be appreciated that shrinking gate pitch can require new approaches for increasing edge placement error (EPE) margin. A recess of the gate or the trench contact, followed by liner formation, metal deposition, and planarization can be used to fabricate a conductive narrow (pin) structure to enable greater scaling than other approaches. In the example of a narrow gate portion (conductive pin), such a pin gate provides for a narrow gate to gate contact via (VCG) connection. The conductive pin structure reduces volume of the metal over the gate for capacitance reduction and enables EPE increase for various COAG approaches.

To provide context, some implementations of Contact-Over-Active-Gate require a selective ("color") etch. An associated process window for the etch may be insufficient. For example, defect modes of opens and shorts may persistently degrade the manufacturing yield. The open circuit defect may also attributed to damascene metallization that is not able to fill into deep and tight spaces. For example, recessing a gate and refilling with SiN followed by recessing the trench contact (TCN) and replacing with SiC or SiOx to establish etch selectivity between the two materials can require outstanding etch selectivity which can be difficult to achieve at scaled dimensions.

Approaches described herein may be more facile to implement than state-of-the-art approaches, and can provide with good process margin. Approaches described herein may be viewed as a COAG method with reduced etch requirements and process operations. In particular embodiments, approaches can be implemented to enable about +/- 10 nm edge placement error (EPE) process margin. Additionally, trench contact via (VCT) and gate contact via (VCG) structures can be patterned together or split. Embodiments may only need a shorter starting gate height than other COAG approaches.

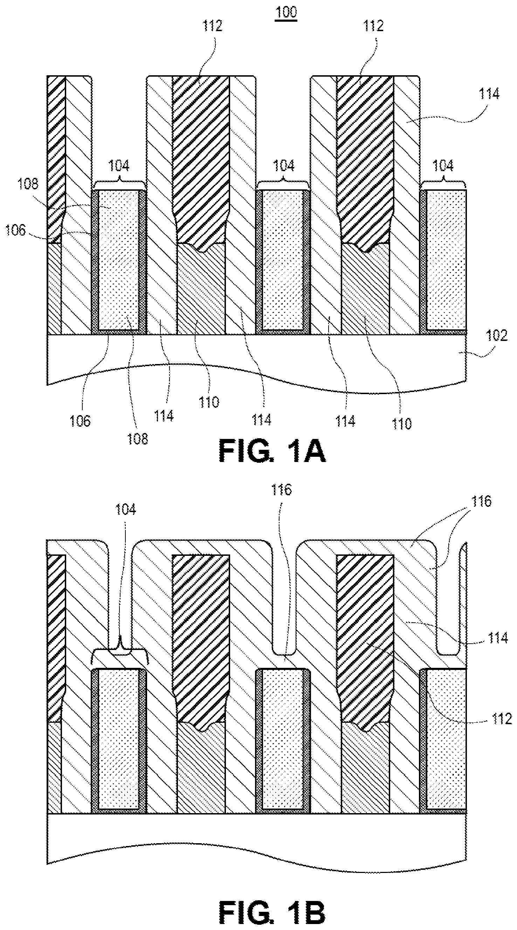

In an exemplary processing scheme, Figures 1A-1D illustrate cross-sectional views illustrating various operations in a method of fabricating narrow conductive structures for gate contact, in accordance with an embodiment of the present disclosure.

Referring to Figure 1A, a starting structure 100 includes a plurality of gate structures 104 above a substrate 102. The gate structures 104 can each include a gate electrode 108 and a gate dielectric 106. Dielectric spacers 114 are formed along sides of the gate structures 104. The gate structures 104 are recessed relative to the dielectric spacers 114. Conductive trench contact structures 112 are between the dielectric spacers 114 of adjacent gate structures 104. The conductive trench contact structures 112 are on corresponding epitaxial source or drain structures 110. The conductive trench contact structures 112 have an uppermost surface co-planar with an uppermost surface of the dielectric spacers 114.

Referring to Figure 1B, a dielectric liner material 116 is formed conformally on the structure of Figure 1A. In an embodiment, the dielectric liner material 116 is composed of a same material as the dielectric spacers 114, e.g., silicon nitride. In another embodiment, the dielectric liner material 116 is composed of a different material than the dielectric spacers 114. In an embodiment, the dielectric liner material 116 has a thickness set to define a target pin gate width ultimately formed laterally between etched portions of the dielectric liner material 116.

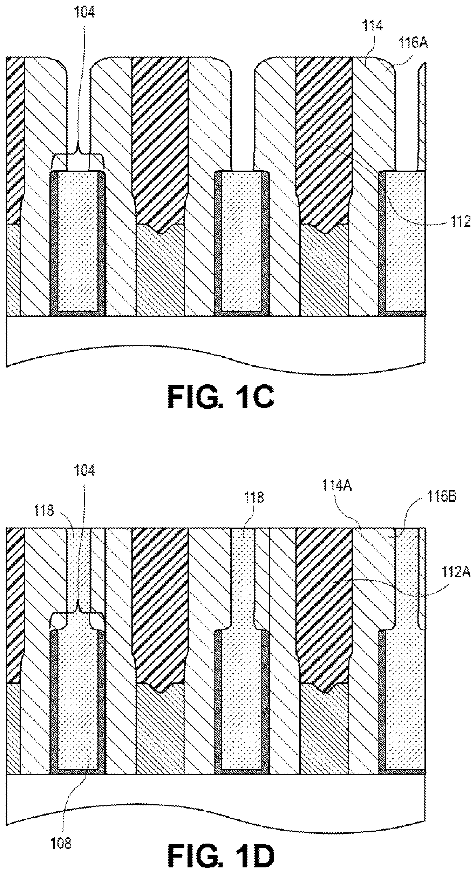

Referring to Figure 1C, the dielectric liner material 116 is anisotropically etched to form dielectric liner 116A along exposed sides of the dielectric spacers 114.

Referring to Figure 1D, a conductive material is formed over the structure of Figure 1C, and the structure is then planarized to form a plurality of conductive pin structures 118 between planarized dielectric liner portions 116B. The planarized dielectric liner portions 116B are along sides of planarized dielectric spacer portions 114A and are co-planar with planarized conductive trench contact structures 112A. The conductive pin structures 118 are in contact with a gate electrode 108 of a corresponding one of the gate structures 104. In an embodiment, the conductive pin structures 118 are formed using a tungsten (W) fill material.

The structure of Figure ID can be further processed to form conductive vias to contact one of the conductive pin structures 118. For example, an interlayer dielectric layer can be formed on the structure, openings then formed in the interlayer dielectric layer, e.g., by a lithography and etch process, to form a patterned interlayer dielectric layer. A conductive via can then be formed in the opening.

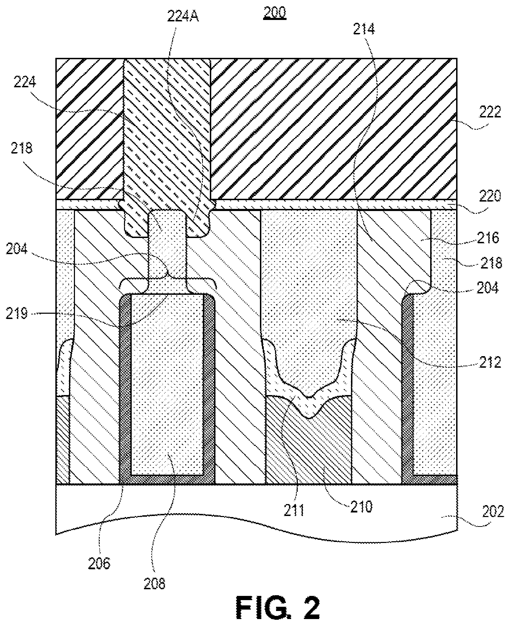

As an exemplary structure, Figure 2 illustrates a cross-sectional view illustrating an integrated circuit structure including a narrow conductive structure for gate contact, in accordance with an embodiment of the present disclosure.

Referring to Figure 2, an integrated circuit structure 200 includes a plurality of gate structures 204 above a substrate 202. Each gate structure 204 includes a gate dielectric 206 and a gate electrode 208. A conductive trench contact structure 212 is between a pair of adjacent gate structure 204. The conductive trench contact structure 212 can be on a conductive liner layer 211 on an epitaxial source or drain structure 210. The integrated circuit structure 200 also includes a plurality of dielectric spacers 214, with a corresponding one of the plurality of dielectric spacers 214 between adjacent gate structures 204 and conductive trench contact structures 212. The plurality of dielectric spacers 214 protrudes above the plurality of gate structures 204 and has an uppermost surface co-planar with an uppermost surface of the conductive trench contact structure 212. A dielectric liner 216 is along the plurality of dielectric spacers 214 over the plurality of gate structures 204. A plurality of conductive pin structures 218 is between the dielectric liner 216. Individual ones of the plurality of conductive pin structures 218 are on corresponding ones of the plurality of gate structures 204, e.g., in electrical contact with the corresponding gate electrode 208. The plurality of conductive pin structures 218 have an uppermost surface co-planar with the uppermost surface of the conductive trench contact structure 212 and co-planar with an uppermost surface of the dielectric liner 216.

With reference again to Figure 2, an interlayer dielectric material 222 is over the conductive trench contact structure 212, over the plurality of dielectric spacers 214, over the dielectric liner 216, and over the plurality of conductive pin structures 218. In one embodiment, the interlayer dielectric material 222 is on an etch stop layer 220. An opening is in the interlayer dielectric material 222 (and in the etch stop layer 220, if included). The opening exposes one of the plurality of conductive pin structures 218. A conductive via 224 is in the opening. The conductive via 224 is in direct contact with the one of the plurality of conductive pin structures 218. In one embodiment, the conductive via 224 has portions 224A that wrap an upper portion of the one of the plurality of conductive pin structures 218.

In an embodiment, the plurality of dielectric spacers 214 have a same composition as the dielectric liner 216, as is depicted. In another embodiment, the plurality of dielectric spacers 214 have a different composition than the dielectric liner 216. In an embodiment, although not depicted, an interface is between the plurality of dielectric spacers 214 and the dielectric liner 216. In an embodiment, an interface 219 is between the individual ones of the plurality of conductive pin structures 218 and the corresponding ones of the plurality of gate structures 204, as is depicted.

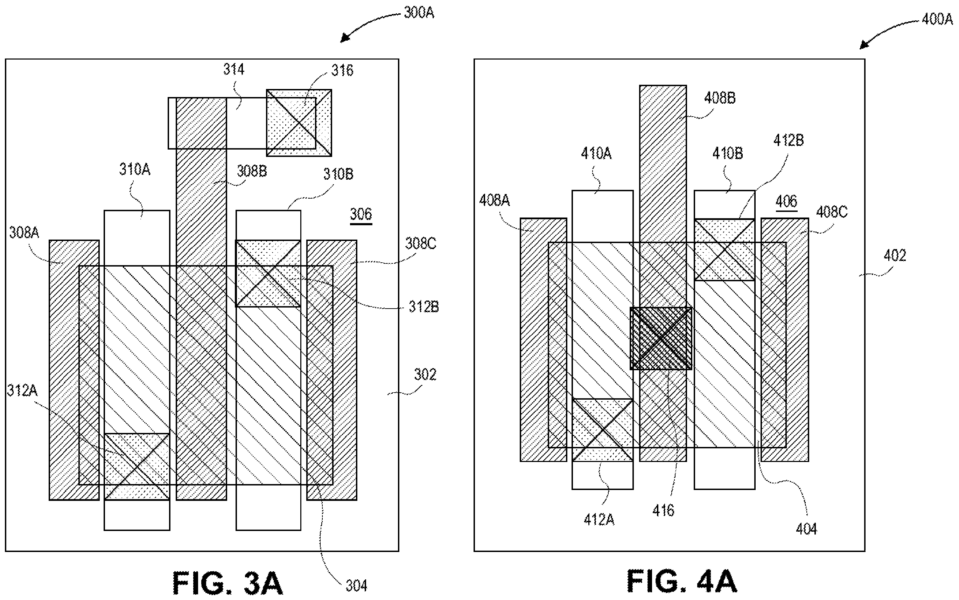

To provide further background for the importance of a COAG processing scheme, in technologies where space and layout constraints are somewhat relaxed compared with current generation space and layout constraints, a contact to gate structure may be fabricated by making contact to a portion of the gate electrode disposed over an isolation region. As an example, Figure 3A illustrates a plan view of a semiconductor device having a gate contact disposed over an inactive portion of a gate electrode.

Referring to Figure 3A, a semiconductor structure or device 300A includes a diffusion or active region 304 disposed in a substrate 302, and within an isolation region 306. One or more gate lines (also known as poly lines), such as gate lines 308A, 308B and 308C are disposed over the diffusion or active region 304 as well as over a portion of the isolation region 306. Source or drain contacts (also known as trench contacts), such as contacts 310A and 310B, are disposed over source and drain regions of the semiconductor structure or device 300A. Trench contact vias 312A and 312B provide contact to trench contacts 310A and 310B, respectively. A separate gate contact 314, and overlying gate contact via 316, provides contact to gate line 308B. In contrast to the source or drain trench contacts 310A or 310B, the gate contact 314 is disposed, from a plan view perspective, over isolation region 306, but not over diffusion or active region 304. Furthermore, neither the gate contact 314 nor gate contact via 316 is disposed between the source or drain trench contacts 310A and 310B.

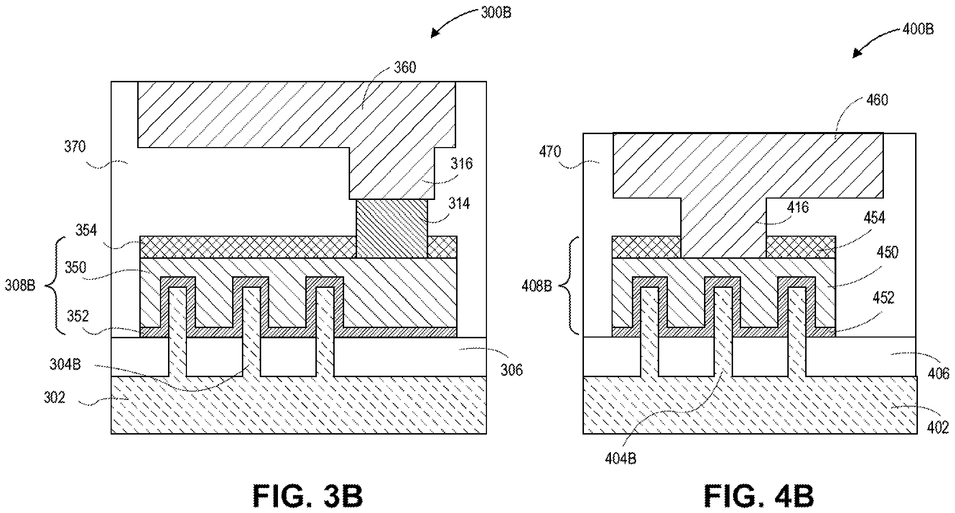

Figure 3B illustrates a cross-sectional view of a non-planar semiconductor device having a gate contact disposed over an inactive portion of a gate electrode. Referring to Figure 3B, a semiconductor structure or device 300B, e.g. a non-planar version of device 300A of Figure 3A, includes a non-planar diffusion or active region 304B (e.g., a fin structure) formed from substrate 302, and within isolation region 306. Gate line 308B is disposed over the non-planar diffusion or active region 304B as well as over a portion of the isolation region 306. As shown, gate line 308B includes a gate electrode 350 and gate dielectric layer 352, along with a dielectric cap layer 354. Gate contact 314, and overlying gate contact via 316 are also seen from this perspective, along with an overlying metal interconnect 360, all of which are disposed in inter-layer dielectric stacks or layers 370. Also seen from the perspective of Figure 3B, the gate contact 314 is disposed over isolation region 306, but not over non-planar diffusion or active region 304B.

Referring again to Figures 3A and 3B, the arrangement of semiconductor structure or device 300A and 300B, respectively, places the gate contact over isolation regions. Such an arrangement wastes layout space. However, placing the gate contact over active regions would require either an extremely tight registration budget or gate dimensions would have to increase to provide enough space to land the gate contact. Furthermore, historically, contact to gate over diffusion regions has been avoided for risk of drilling through other gate material (e.g., polysilicon) and contacting the underlying active region. One or more embodiments described herein address the above issues by providing feasible approaches, and the resulting structures, to fabricating contact structures that contact portions of a gate electrode formed over a diffusion or active region.

As an example, Figure 4A illustrates a plan view of a semiconductor device having a gate contact via disposed over an active portion of a gate electrode, in accordance with an embodiment of the present disclosure. Referring to Figure 4A, a semiconductor structure or device 400A includes a diffusion or active region 404 disposed in a substrate 402, and within an isolation region 406. One or more gate lines, such as gate lines 408A, 408B and 408C are disposed over the diffusion or active region 404 as well as over a portion of the isolation region 406. Source or drain trench contacts, such as trench contacts 410A and 410B, are disposed over source and drain regions of the semiconductor structure or device 400A. Trench contact vias 412A and 412B provide contact to trench contacts 410A and 410B, respectively. A gate contact via 416, with no intervening separate gate contact layer, provides contact to gate line 408B. In contrast to Figure 1A, the gate contact 416 is disposed, from a plan view perspective, over the diffusion or active region 404 and between the source or drain contacts 410A and 410B.

Figure 4B illustrates a cross-sectional view of a non-planar semiconductor device having a gate contact via disposed over an active portion of a gate electrode, in accordance with an embodiment of the present disclosure. Referring to Figure 4B, a semiconductor structure or device 400B, e.g. a non-planar version of device 400A of Figure 4A, includes a non-planar diffusion or active region 404B (e.g., a fin structure) formed from substrate 402, and within isolation region 406. Gate line 408B is disposed over the non-planar diffusion or active region 404B as well as over a portion of the isolation region 406. As shown, gate line 408B includes a gate electrode 450 and gate dielectric layer 452, along with a dielectric cap layer 454. The gate contact via 416 is also seen from this perspective, along with an overlying metal interconnect 460, both of which are disposed in inter-layer dielectric stacks or layers 470. Also seen from the perspective of Figure 4B, the gate contact via 416 is disposed over non-planar diffusion or active region 404B.

Thus, referring again to Figures 4A and 4B, in an embodiment, trench contact vias 412A, 412B and gate contact via 416 are formed in a same layer and are essentially co-planar. In comparison to Figures 1A and 1B, the contact to the gate line would otherwise include and additional gate contact layer, e.g., which could be run perpendicular to the corresponding gate line. In the structure(s) described in association with Figures 4A and 4B, however, the fabrication of structures 400A and 400B, respectively, enables the landing of a contact directly from a metal interconnect layer on an active gate portion without shorting to adjacent source drain regions. In an embodiment, such an arrangement provides a large area reduction in circuit layout by eliminating the need to extend transistor gates on isolation to form a reliable contact. As used throughout, in an embodiment, reference to an active portion of a gate refers to that portion of a gate line or structure disposed over (from a plan view perspective) an active or diffusion region of an underlying substrate. In an embodiment, reference to an inactive portion of a gate refers to that portion of a gate line or structure disposed over (from a plan view perspective) an isolation region of an underlying substrate.

In an embodiment, the semiconductor structure or device 400 is a non-planar device such as, but not limited to, a fin-FET or a tri-gate device. In such an embodiment, a corresponding semiconducting channel region is composed of or is formed in a three-dimensional body. In one such embodiment, the gate electrode stacks of gate lines 408A and 408B surround at least a top surface and a pair of sidewalls of the three-dimensional body. In another embodiment, at least the channel region is made to be a discrete three-dimensional body, such as in a gate-all-around device. In one such embodiment, the gate electrode stacks of gate lines 408A and 408B each completely surrounds the channel region.

Generally, one or more embodiments are directed to approaches for, and structures formed from, landing a gate contact via directly on an active transistor gate. Such approaches may eliminate the need for extension of a gate line on isolation for contact purposes. Such approaches may also eliminate the need for a separate gate contact (GCN) layer to conduct signals from a gate line or structure. In an embodiment, eliminating the above features is achieved by recessing gate structure materials, and introducing an additional dielectric liner in the process flow.

To provide further context, some implementations of COAG impose tight controls on multiple modules such as gate and contact recess, dielectric hard masks deposition, and dielectric polish to ensure uniformity of the etch selective ("colored") hardmasks and strict adherence of the hardmask thickness to specifications. Limited etch selectivity of the color etches may leave little room for any upstream process deviations typical of a manufacturing line. The COAG implementations may not provide a robust process window that eliminates all opens and shorts.

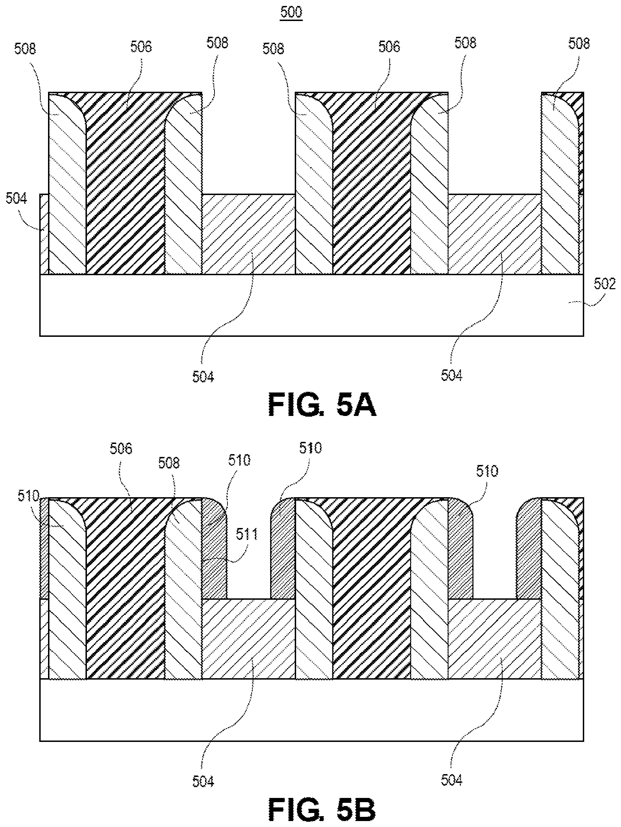

In accordance with one or more embodiments of the present disclosure, a process flow is implemented which involves recessing the gates between spacers to enable an increase in edge placement error margin and enable contacts over active gates. The process can enable the fabrication of contacts over active gates for device scaling. Although described extensively with respect to forming conductive pin structures for gate electrodes, embodiments described herein can similarly be implemented to fabricate conductive pin structures for conductive trench contacts. As a more generic processing scheme, Figures 5A-5D illustrate cross-sectional views illustrating various operations in a method of fabricating narrow conductive structures for gate contact or trench contact, in accordance with an embodiment of the present disclosure.

Referring to Figure 5A, a starting structure 500 includes a plurality of conductive structures 504 above a substrate 502. Dielectric spacers 508 are formed along sides of the conductive structures 504. The conductive structures 504 are recessed relative to the dielectric spacers 508. Conductive structures 506 are between the dielectric spacers 508 of adjacent conductive structures 504. The conductive structures 506 have an uppermost surface co-planar with an uppermost surface of the dielectric spacers 508.

Referring to Figure 5B, a dielectric liner 510 is formed along exposed sides of the dielectric spacers 508. In an embodiment, not depicted, the plurality of dielectric spacers 508 have a same composition as the dielectric liner 510. In another embodiment, the plurality of dielectric spacers 508 have a different composition than the dielectric liner 510, as is depicted. In an embodiment, an interface 511 is between the plurality of dielectric spacers 508 and the dielectric liner 510, as is depicted.

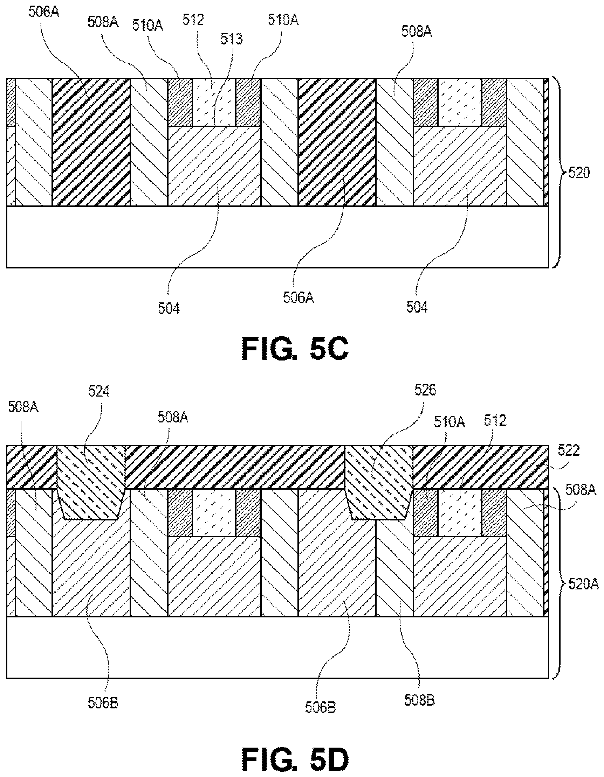

Referring to Figure 5C, a conductive material is formed over the structure of Figure 5B, and the structure is then planarized to form a structure 520 including a plurality of conductive pin structures 512 between planarized dielectric liner portions 510A. The planarized dielectric liner portions 510A are along sides of planarized dielectric spacer portions 508A and are co-planar with planarized conductive structures 506A. The conductive pin structures 512 are in contact with a corresponding one of the conductive structures 504. In an embodiment, an interface 513 is between the individual ones of the plurality of conductive pin structures 512 and the corresponding ones of the plurality of conductive structures 504, as is depicted.

Referring to Figure 5D, an interlayer dielectric material 522 is formed over the structure 520 of Figure 5C. Openings are formed in the interlayer dielectric material 522. The openings expose select ones of the planarized conductive structures 506A. Conductive vias 524 and 526 are formed in the openings. In one embodiment, the conductive via 524 represents a properly aligned conductive via that lands within a footprint of the corresponding planarized conductive structure 506A. In one embodiment, the conductive via 526 represents a mis-aligned conductive via that lands partially outside of a footprint of the corresponding planarized conductive structure 506A. As shown, the conductive liner 510A inhibits the mis-aligned via 526 from shorting to the conductive pin structure 512 immediately to the right of the mis-aligned via 526. In an embodiment, the conductive vias 524 and 526 extend partially into the structure 520 to form partially recessed structure 520A including recessed conductive structures 506B and a recessed spacer 508B.

With reference again to Figures 5A-5D, in an embodiment, although not depicted, a conductive via is formed to contact one of the conductive pin structures 518, as described in association with Figure 2. In an embodiment, conductive structures 504 are gate structures, and conductive structures 506 are conductive trench contact structures. In another embodiment, conductive structures 506 are gate structures, and conductive structures 504 are conductive trench contact structures.

As an exemplary fabrication scheme, a starting structure includes one or more gate stack structures disposed above a substrate. The gate stack structures may include a gate dielectric layer and a gate electrode. Trench contacts, e.g., contacts to diffusion regions of the substrate or to epitaxial region formed within the substrate are spaced apart from gate stack structures by dielectric spacers. In an embodiment, the contact pattern is essentially perfectly aligned to an existing gate pattern while eliminating the use of a lithographic operation with exceedingly tight registration budget. In one such embodiment, this approach enables the use of intrinsically highly selective wet etching (or anisotropic dry etch processes some of which are non-plasma, gas phase isotropic etches (e.g., versus classic dry or plasma etching) to generate contact openings. In an embodiment, a contact pattern is formed by utilizing an existing gate pattern in combination with a contact plug lithography operation. In one such embodiment, the approach enables elimination of the need for an otherwise critical lithography operation to generate a contact pattern, as used in other approaches. This also allows for perfect or near-perfect self-alignment with a larger edge placement error margin. In an embodiment, a trench contact grid is not separately patterned, but is rather formed between poly (gate) lines. For example, in one such embodiment, a trench contact grid is formed subsequent to gate grating patterning but prior to gate grating cuts.

Furthermore, the gate stack structures may be fabricated by a replacement gate process. In such a scheme, dummy gate material such as polysilicon or silicon nitride pillar material, may be removed and replaced with permanent gate electrode material. In one such embodiment, a permanent gate dielectric layer is also formed in this process, as opposed to being carried through from earlier processing. In an embodiment, dummy gates are removed by a dry etch or wet etch process. In one embodiment, dummy gates are composed of poly crystalline silicon or amorphous silicon and are removed with a dry etch process including SF₆. In another embodiment, dummy gates are composed of polycrystalline silicon or amorphous silicon and are removed with a wet etch process including aqueous NH₄OH or tetramethylammonium hydroxide. In one embodiment, dummy gates are composed of silicon nitride and are removed with a wet etch including aqueous phosphoric acid.

In an embodiment, one or more approaches described herein contemplate essentially a dummy and replacement gate process in combination with a dummy and replacement contact process. In one such embodiment, the replacement contact process is performed after the replacement gate process to allow high temperature anneal of at least a portion of the permanent gate stack. For example, in a specific such embodiment, an anneal of at least a portion of the permanent gate structures, e.g., after a gate dielectric layer is formed, is performed at a temperature greater than approximately 600 degrees Celsius. The anneal is performed prior to formation of the permanent contacts.

Next, the permanent gate structures may be recessed to provide recessed gate structures that have a height below the top surface of the adjacent spacers. An insulating liner is then formed on the recessed gate structures. Gate contacts may then be formed.

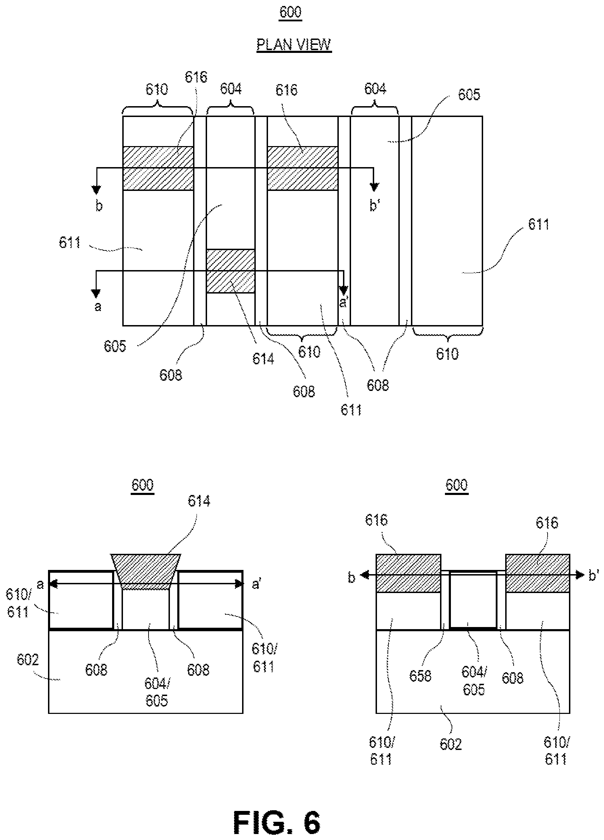

As an exemplary generic structure showing possible contact layouts, Figure 6 illustrates a plan view and corresponding cross-sectional views of an integrated circuit structure having trench contacts and a gate contact, in accordance with an embodiment of the present disclosure.

Referring to Figure 6, an integrated circuit structure 600 includes a gate line 604 above a semiconductor substrate or fin 602, such as a silicon fin. The gate line 604 includes a gate stack 605 (e.g., including a gate dielectric layer or stack and a gate electrode on the gate dielectric layer or stack). Dielectric spacers 608 are along sidewalls of the gate stack 605. Trench contacts 610 are adjacent the sidewalls of the gate line 604, with the dielectric spacers 608 between the gate line 604 and the trench contacts 610. Individual ones of the trench contacts 610 include a conductive contact structure 611.

Referring again to Figure 6, a gate contact via 614 is formed on a gate stack 605. In an embodiment, the gate contact via 614 electrically contacts the gate stack 605 at a location over the semiconductor substrate or fin 602 and laterally between the trench contacts 610, as is depicted. In an embodiment, although not depicted, the gate contact via 614 lands on a conductive pin structure of a gate electrode of the gate line 604.

Referring again to Figure 6, trench contact vias 616 electrically contact the respective conductive contact structures 611. In an embodiment, the trench contact vias 616 electrically contact the respective conductive contact structures 611 at locations laterally adjacent the gate stack 605 of the gate line 604, as is depicted.

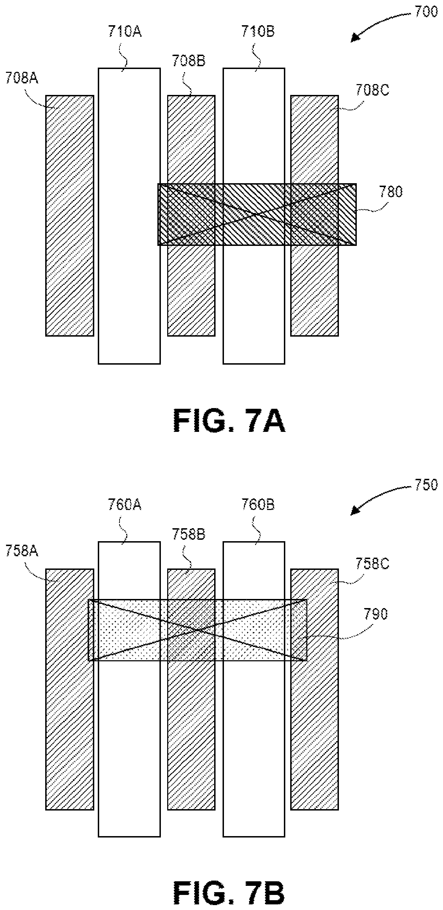

The approaches and structures described herein may enable formation of other structures or devices that were not possible or difficult to fabricate using other methodologies. In a first example, Figure 7A illustrates a plan view of another semiconductor device having a gate contact via disposed over an active portion of a gate, in accordance with another embodiment of the present disclosure. Referring to Figure 7A, a semiconductor structure or device 700 includes a plurality of gate structures 708A-708C interdigitated with a plurality of trench contacts 710A and 710B (these features are disposed above an active region of a substrate, not shown). A gate contact via 780 is formed on an active portion the gate structure 708B. The gate contact via 780 is further disposed on the active portion of the gate structure 708C, coupling gate structures 708B and 708C. It is to be appreciated that the intervening trench contact 710B may be isolated from the contact 780 by insulating layers which can include a dielectric liner as described above. The contact configuration of Figure 7A may provide an easier approach to strapping adjacent gate lines in a layout, hence enabling smaller cell areas or less intricate wiring schemes, or both.

In a second example, Figure 7B illustrates a plan view of another semiconductor device having a trench contact via coupling a pair of trench contacts, in accordance with another embodiment of the present disclosure. Referring to Figure 7B, a semiconductor structure or device 750 includes a plurality of gate structures 758A-758C interdigitated with a plurality of trench contacts 760A and 760B (these features are disposed above an active region of a substrate, not shown). A trench contact via 790 is formed on the trench contact 760A. The trench contact via 790 is further disposed on the trench contact 760B, coupling trench contacts 760A and 760B. It is to be appreciated that the intervening gate structure 758B may be isolated from the trench contact via 790 by insulating layers which can include a dielectric liner as described above. The contact configuration of Figure 7B may provide an easier approach to strapping adjacent trench contacts in a layout, hence enabling smaller cell areas or less intricate wiring schemes, or both.

As described throughout the present application, a substrate may be composed of a semiconductor material that can withstand a manufacturing process and in which charge can migrate. In an embodiment, a substrate is described herein is a bulk substrate composed of a crystalline silicon, silicon/germanium or germanium layer doped with a charge carrier, such as but not limited to phosphorus, arsenic, boron or a combination thereof, to form an active region. In one embodiment, the concentration of silicon atoms in such a bulk substrate is greater than 97%. In another embodiment, a bulk substrate is composed of an epitaxial layer grown atop a distinct crystalline substrate, e.g. a silicon epitaxial layer grown atop a boron-doped bulk silicon mono-crystalline substrate. A bulk substrate may alternatively be composed of a group III-V material. In an embodiment, a bulk substrate is composed of a group III-V material such as, but not limited to, gallium nitride, gallium phosphide, gallium arsenide, indium phosphide, indium antimonide, indium gallium arsenide, aluminum gallium arsenide, indium gallium phosphide, or a combination thereof. In one embodiment, a bulk substrate is composed of a group III-V material and the charge-carrier dopant impurity atoms are ones such as, but not limited to, carbon, silicon, germanium, oxygen, sulfur, selenium or tellurium.

As described throughout the present application, isolation regions such as shallow trench isolation regions or sub-fin isolation regions may be composed of a material suitable to ultimately electrically isolate, or contribute to the isolation of, portions of a permanent gate structure from an underlying bulk substrate or to isolate active regions formed within an underlying bulk substrate, such as isolating fin active regions. For example, in one embodiment, an isolation region is composed of one or more layers of a dielectric material such as, but not limited to, silicon dioxide, silicon oxy-nitride, silicon nitride, carbon-doped silicon nitride, or a combination thereof.

As described throughout the present application, gate lines or gate structures may be composed of a gate electrode stack which includes a gate dielectric layer and a gate electrode layer. In an embodiment, the gate electrode of the gate electrode stack is composed of a metal gate and the gate dielectric layer is composed of a high-k material. For example, in one embodiment, the gate dielectric layer is composed of a material such as, but not limited to, hafnium oxide, hafnium oxy-nitride, hafnium silicate, lanthanum oxide, zirconium oxide, zirconium silicate, tantalum oxide, barium strontium titanate, barium titanate, strontium titanate, yttrium oxide, aluminum oxide, lead scandium tantalum oxide, lead zinc niobate, or a combination thereof. Furthermore, a portion of gate dielectric layer may include a layer of native oxide formed from the top few layers of a semiconductor substrate. In an embodiment, the gate dielectric layer is composed of a top high-k portion and a lower portion composed of an oxide of a semiconductor material. In one embodiment, the gate dielectric layer is composed of a top portion of hafnium oxide and a bottom portion of silicon dioxide or silicon oxy-nitride. In some implementations, a portion of the gate dielectric is a "U"-shaped structure that includes a bottom portion substantially parallel to the surface of the substrate and two sidewall portions that are substantially perpendicular to the top surface of the substrate.

In one embodiment, a gate electrode is composed of a metal layer such as, but not limited to, metal nitrides, metal carbides, metal silicides, metal aluminides, hafnium, zirconium, titanium, tantalum, aluminum, ruthenium, palladium, platinum, cobalt, nickel or conductive metal oxides. In a specific embodiment, the gate electrode is composed of a non-workfunction-setting fill material formed above a metal workfunction-setting layer. The gate electrode layer may consist of a P-type workfunction metal or an N-type workfunction metal, depending on whether the transistor is to be a PMOS or an NMOS transistor. In some implementations, the gate electrode layer may consist of a stack of two or more metal layers, where one or more metal layers are workfunction metal layers and at least one metal layer is a conductive fill layer. For a PMOS transistor, metals that may be used for the gate electrode include, but are not limited to, ruthenium, palladium, platinum, cobalt, nickel, and conductive metal oxides, e.g., ruthenium oxide. A P-type metal layer will enable the formation of a PMOS gate electrode with a workfunction that is between about 4.9 eV and about 5.2 eV. For an NMOS transistor, metals that may be used for the gate electrode include, but are not limited to, hafnium, zirconium, titanium, tantalum, aluminum, alloys of these metals, and carbides of these metals such as hafnium carbide, zirconium carbide, titanium carbide, tantalum carbide, and aluminum carbide. An N-type metal layer will enable the formation of an NMOS gate electrode with a workfunction that is between about 3.9 eV and about 4.2 eV. In some implementations, the gate electrode may consist of a "U"-shaped structure that includes a bottom portion substantially parallel to the surface of the substrate and two sidewall portions that are substantially perpendicular to the top surface of the substrate. In another implementation, at least one of the metal layers that form the gate electrode may simply be a planar layer that is substantially parallel to the top surface of the substrate and does not include sidewall portions substantially perpendicular to the top surface of the substrate. In further implementations of the disclosure, the gate electrode may consist of a combination of U-shaped structures and planar, non-U-shaped structures. For example, the gate electrode may consist of one or more U-shaped metal layers formed atop one or more planar, non-U-shaped layers.

As described throughout the present application, spacers associated with gate lines or electrode stacks may be composed of a material suitable to ultimately electrically isolate, or contribute to the isolation of, a permanent gate structure from adjacent conductive contacts, such as self-aligned contacts. For example, in one embodiment, the spacers are composed of a dielectric material such as, but not limited to, silicon dioxide, silicon oxy-nitride, silicon nitride, or carbon-doped silicon nitride.

In an embodiment, as used throughout the present description, interlayer dielectric (ILD) material is composed of or includes a layer of a dielectric or insulating material. Examples of suitable dielectric materials include, but are not limited to, oxides of silicon (e.g., silicon dioxide (SiO₂)), doped oxides of silicon, fluorinated oxides of silicon, carbon doped oxides of silicon, various low-k dielectric materials known in the arts, and combinations thereof. The interlayer dielectric material may be formed by techniques, such as, for example, chemical vapor deposition (CVD), physical vapor deposition (PVD), or by other deposition methods.

In an embodiment, as is also used throughout the present description, metal lines or interconnect line material (and via material) is composed of one or more metal or other conductive structures. A common example is the use of copper lines and structures that may or may not include barrier layers between the copper and surrounding ILD material. As used herein, the term metal includes alloys, stacks, and other combinations of multiple metals. For example, the metal interconnect lines may include barrier layers (e.g., layers including one or more of Ta, TaN, Ti or TiN), stacks of different metals or alloys, etc. Thus, the interconnect lines may be a single material layer, or may be formed from several layers, including conductive liner layers and fill layers. Any suitable deposition process, such as electroplating, chemical vapor deposition or physical vapor deposition, may be used to form interconnect lines. In an embodiment, the interconnect lines are composed of a conductive material such as, but not limited to, Cu, Al, Ti, Zr, Hf, V, Ru, Co, Ni, Pd, Pt, W, Ag, Au or alloys thereof. The interconnect lines are also sometimes referred to in the art as traces, wires, lines, metal, or simply interconnect.

In an embodiment, as is also used throughout the present description, hardmask materials are composed of dielectric materials different from the interlayer dielectric material. In one embodiment, different hardmask materials may be used in different regions so as to provide different growth or etch selectivity to each other and to the underlying dielectric and metal layers. In some embodiments, a hardmask layer includes a layer of a nitride of silicon (e.g., silicon nitride) or a layer of an oxide of silicon, or both, or a combination thereof. Other suitable materials may include carbon-based materials. In another embodiment, a hardmask material includes a metal species. For example, a hardmask or other overlying material may include a layer of a nitride of titanium or another metal (e.g., titanium nitride). Potentially lesser amounts of other materials, such as oxygen, may be included in one or more of these layers. Alternatively, other hardmask layers known in the arts may be used depending upon the particular implementation. The hardmask layers maybe formed by CVD, PVD, or by other deposition methods.

In an embodiment, as is also used throughout the present description, lithographic operations are performed using 193nm immersion lithography (i193), extreme ultra-violet (EUV) lithography or electron beam direct write (EBDW) lithography, or the like. A positive tone or a negative tone resist may be used. In one embodiment, a lithographic mask is a trilayer mask composed of a topographic masking portion, an anti-reflective coating (ARC) layer, and a photoresist layer. In a particular such embodiment, the topographic masking portion is a carbon hardmask (CHM) layer and the anti-reflective coating layer is a silicon ARC layer.

In an embodiment, approaches described herein may involve formation of a contact pattern which is very well aligned to an existing gate pattern while eliminating the use of a lithographic operation with exceedingly tight registration budget. In one such embodiment, this approach enables the use of intrinsically highly selective wet etching (e.g., versus dry or plasma etching) to generate contact openings. In an embodiment, a contact pattern is formed by utilizing an existing gate pattern in combination with a contact plug lithography operation. In one such embodiment, the approach enables elimination of the need for an otherwise critical lithography operation to generate a contact pattern, as used in other approaches. In an embodiment, a trench contact grid is not separately patterned, but is rather formed between poly (gate) lines. For example, in one such embodiment, a trench contact grid is formed subsequent to gate grating patterning but prior to gate grating cuts.

Furthermore, a gate stack structure may be fabricated by a replacement gate process. In such a scheme, dummy gate material such as polysilicon or silicon nitride pillar material, may be removed and replaced with permanent gate electrode material. In one such embodiment, a permanent gate dielectric layer is also formed in this process, as opposed to being carried through from earlier processing. In an embodiment, dummy gates are removed by a dry etch or wet etch process. In one embodiment, dummy gates are composed of poly crystalline silicon or amorphous silicon and are removed with a dry etch process including use of SF₆. In another embodiment, dummy gates are composed of polycrystalline silicon or amorphous silicon and are removed with a wet etch process including use of aqueous NH₄OH or tetramethylammonium hydroxide. In one embodiment, dummy gates are composed of silicon nitride and are removed with a wet etch including aqueous phosphoric acid.

In an embodiment, one or more approaches described herein contemplate essentially a dummy and replacement gate process in combination with a dummy and replacement contact process to arrive at structure. In one such embodiment, the replacement contact process is performed after the replacement gate process to allow high temperature anneal of at least a portion of the permanent gate stack. For example, in a specific such embodiment, an anneal of at least a portion of the permanent gate structures, e.g., after a gate dielectric layer is formed, is performed at a temperature greater than approximately 600 degrees Celsius. The anneal is performed prior to formation of the permanent contacts.

In some embodiments, the arrangement of a semiconductor structure or device places a gate contact over portions of a gate line or gate stack over isolation regions. However, such an arrangement may be viewed as inefficient use of layout space. In another embodiment, a semiconductor device has contact structures that contact portions of a gate electrode formed over an active region. In general, prior to (e.g., in addition to) forming a gate contact structure (such as a via) over an active portion of a gate and in a same layer as a trench contact via, one or more embodiments of the present disclosure include first using a gate aligned trench contact process. Such a process may be implemented to form trench contact structures for semiconductor structure fabrication, e.g., for integrated circuit fabrication. In an embodiment, a trench contact pattern is formed as aligned to an existing gate pattern. By contrast, other approaches typically involve an additional lithography process with tight registration of a lithographic contact pattern to an existing gate pattern in combination with selective contact etches. For example, another process may include patterning of a poly (gate) grid with separate patterning of contact features.

It is to be appreciated that pitch division processing and patterning schemes may be implemented to enable embodiments described herein or may be included as part of embodiments described herein. Pitch division patterning typically refers to pitch halving, pitch quartering etc. Pitch division schemes may be applicable to FEOL processing, BEOL processing, or both FEOL (device) and BEOL (metallization) processing. In accordance with one or more embodiments described herein, optical lithography is first implemented to print unidirectional lines (e.g., either strictly unidirectional or predominantly unidirectional) in a pre-defined pitch. Pitch division processing is then implemented as a technique to increase line density.

In an embodiment, the term "grating structure" for fins, gate lines, metal lines, ILD lines or hardmask lines is used herein to refer to a tight pitch grating structure. In one such embodiment, the tight pitch is not achievable directly through a selected lithography. For example, a pattern based on a selected lithography may first be formed, but the pitch may be halved by the use of spacer mask patterning, as is known in the art. Even further, the original pitch may be quartered by a second round of spacer mask patterning. Accordingly, the grating-like patterns described herein may have metal lines, ILD lines or hardmask lines spaced at a substantially consistent pitch and having a substantially consistent width. For example, in some embodiments the pitch variation would be within ten percent and the width variation would be within ten percent, and in some embodiments, the pitch variation would be within five percent and the width variation would be within five percent. The pattern may be fabricated by a pitch halving or pitch quartering, or other pitch division, approach. In an embodiment, the grating is not necessarily single pitch.

In an embodiment, a blanket film is patterned using lithography and etch processing which may involve, e.g., spacer-based-double-patterning (SBDP) or pitch halving, or spacer-based-quadruple-patterning (SBQP) or pitch quartering. It is to be appreciated that other pitch division approaches may also be implemented. In any case, in an embodiment, a gridded layout may be fabricated by a selected lithography approach, such as 193nm immersion lithography (193i). Pitch division may be implemented to increase the density of lines in the gridded layout by a factor of n. Gridded layout formation with 193i lithography plus pitch division by a factor of 'n' can be designated as 193i + P/n Pitch Division. In one such embodiment, 193nm immersion scaling can be extended for many generations with cost effective pitch division.

It is also to be appreciated that not all aspects of the processes described above need be practiced to fall within the spirit and scope of embodiments of the present disclosure. For example, in one embodiment, dummy gates need not ever be formed prior to fabricating gate contacts over active portions of the gate stacks. The gate stacks described above may actually be permanent gate stacks as initially formed. Also, the processes described herein may be used to fabricate one or a plurality of semiconductor devices. The semiconductor devices may be transistors or like devices. For example, in an embodiment, the semiconductor devices are a metal-oxide semiconductor (MOS) transistors for logic or memory, or are bipolar transistors. Also, in an embodiment, the semiconductor devices have a three-dimensional architecture, such as a trigate device, an independently accessed double gate device, or a FIN-FET. One or more embodiments may be particularly useful for fabricating semiconductor devices at a 10 nanometer (10 nm) technology node or sub-10 nanometer (10 nm) technology node. Embodiments described herein can also be implemented for gate all-around (GAA) architectures, such as nanowire or nanoribbon architectures.

Additional or intermediate operations for FEOL layer or structure fabrication may include standard microelectronic fabrication processes such as lithography, etch, thin films deposition, planarization (such as chemical mechanical polishing (CMP)), diffusion, metrology, the use of sacrificial layers, the use of etch stop layers, the use of planarization stop layers, or any other associated action with microelectronic component fabrication. Also, it is to be appreciated that the process operations described for the preceding process flows may be practiced in alternative sequences, not every operation need be performed or additional process operations may be performed, or both.

Embodiments disclosed herein may be used to manufacture a wide variety of different types of integrated circuits or microelectronic devices. Examples of such integrated circuits include, but are not limited to, processors, chipset components, graphics processors, digital signal processors, micro-controllers, and the like. In other embodiments, semiconductor memory may be manufactured. Moreover, the integrated circuits or other microelectronic devices may be used in a wide variety of electronic devices known in the arts. For example, in computer systems (e.g., desktop, laptop, server), cellular phones, personal electronics, etc. The integrated circuits may be coupled with a bus and other components in the systems. For example, a processor may be coupled by one or more buses to a memory, a chipset, etc. Each of the processor, the memory, and the chipset, may potentially be manufactured using the approaches disclosed herein.

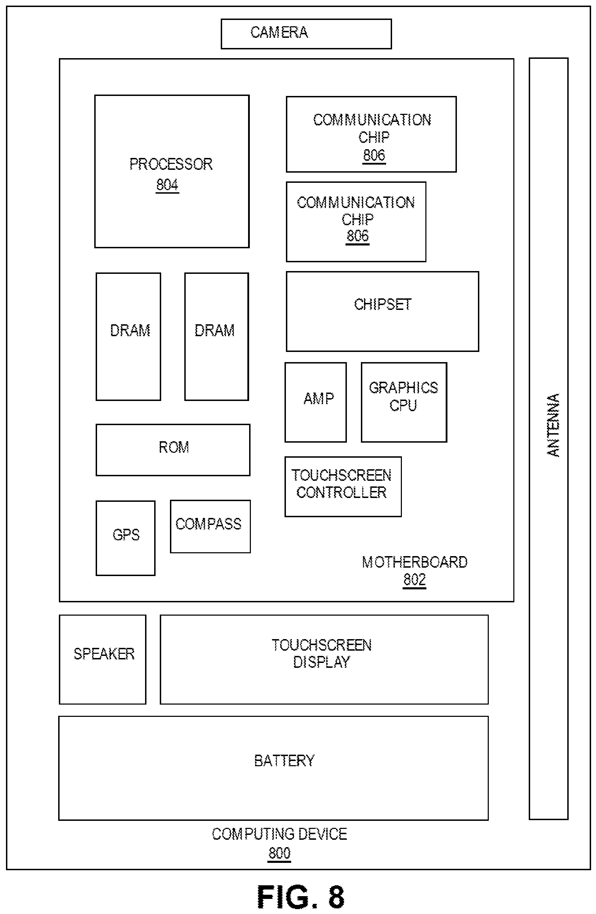

Figure 8 illustrates a computing device 800 in accordance with one implementation of the disclosure. The computing device 800 houses a board 802. The board 802 may include a number of components, including but not limited to a processor 804 and at least one communication chip 806. The processor 804 is physically and electrically coupled to the board 802. In some implementations the at least one communication chip 806 is also physically and electrically coupled to the board 802. In further implementations, the communication chip 806 is part of the processor 804.

Depending on its applications, computing device 800 may include other components that may or may not be physically and electrically coupled to the board 802. These other components include, but are not limited to, volatile memory (e.g., DRAM), non-volatile memory (e.g., ROM), flash memory, a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth).

The communication chip 806 enables wireless communications for the transfer of data to and from the computing device 800. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 806 may implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing device 800 may include a plurality of communication chips 806. For instance, a first communication chip 806 may be dedicated to shorter range wireless communications such as Wi-Fi and Bluetooth and a second communication chip 806 may be dedicated to longer range wireless communications such as GPS, EDGE, GPRS, CDMA, WiMAX, LTE, Ev-DO, and others.

The processor 804 of the computing device 800 includes an integrated circuit die packaged within the processor 804. In some implementations of embodiments of the disclosure, the integrated circuit die of the processor includes one or more structures, such as integrated circuit structures built in accordance with implementations of the disclosure. The term "processor" may refer to any device or portion of a device that processes electronic data from registers or memory to transform that electronic data, or both, into other electronic data that may be stored in registers or memory, or both.

The communication chip 806 also includes an integrated circuit die packaged within the communication chip 806. In accordance with another implementation of the disclosure, the integrated circuit die of the communication chip is built in accordance with implementations of the disclosure.

In further implementations, another component housed within the computing device 800 may contain an integrated circuit die built in accordance with implementations of embodiments of the disclosure.

In various embodiments, the computing device 800 may be a laptop, a netbook, a notebook, an ultrabook, a smartphone, a tablet, a personal digital assistant (PDA), an ultramobile PC, a mobile phone, a desktop computer, a server, a printer, a scanner, a monitor, a set-top box, an entertainment control unit, a digital camera, a portable music player, or a digital video recorder. In further implementations, the computing device 800 may be any other electronic device that processes data.

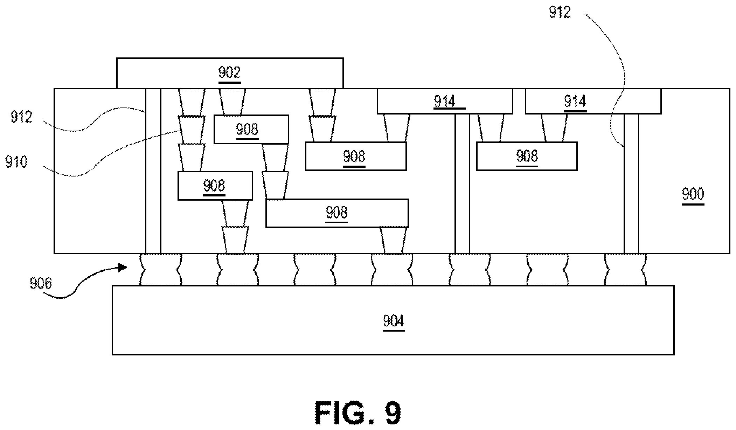

Figure 9 illustrates an interposer 900 that includes one or more embodiments of the disclosure. The interposer 900 is an intervening substrate used to bridge a first substrate 902 to a second substrate 904. The first substrate 902 may be, for instance, an integrated circuit die. The second substrate 904 may be, for instance, a memory module, a computer motherboard, or another integrated circuit die. Generally, the purpose of an interposer 900 is to spread a connection to a wider pitch or to reroute a connection to a different connection. For example, an interposer 900 may couple an integrated circuit die to a ball grid array (BGA) 906 that can subsequently be coupled to the second substrate 904. In some embodiments, the first and second substrates 902/904 are attached to opposing sides of the interposer 900. In other embodiments, the first and second substrates 902/904 are attached to the same side of the interposer 900. And in further embodiments, three or more substrates are interconnected by way of the interposer 900.

The interposer 900 may be formed of an epoxy resin, a fiberglass-reinforced epoxy resin, a ceramic material, or a polymer material such as polyimide. In further implementations, the interposer 900 may be formed of alternate rigid or flexible materials that may include the same materials described above for use in a semiconductor substrate, such as silicon, germanium, and other group III-V and group IV materials.

The interposer 900 may include metal interconnects 908 and vias 910, including but not limited to through-silicon vias (TSVs) 912. The interposer 900 may further include embedded devices 914, including both passive and active devices. Such devices include, but are not limited to, capacitors, decoupling capacitors, resistors, inductors, fuses, diodes, transformers, sensors, and electrostatic discharge (ESD) devices. More complex devices such as radio-frequency (RF) devices, power amplifiers, power management devices, antennas, arrays, sensors, and MEMS devices may also be formed on the interposer 900. In accordance with embodiments of the disclosure, apparatuses or processes disclosed herein may be used in the fabrication of interposer 900 or in the fabrication of components included in the interposer 900.

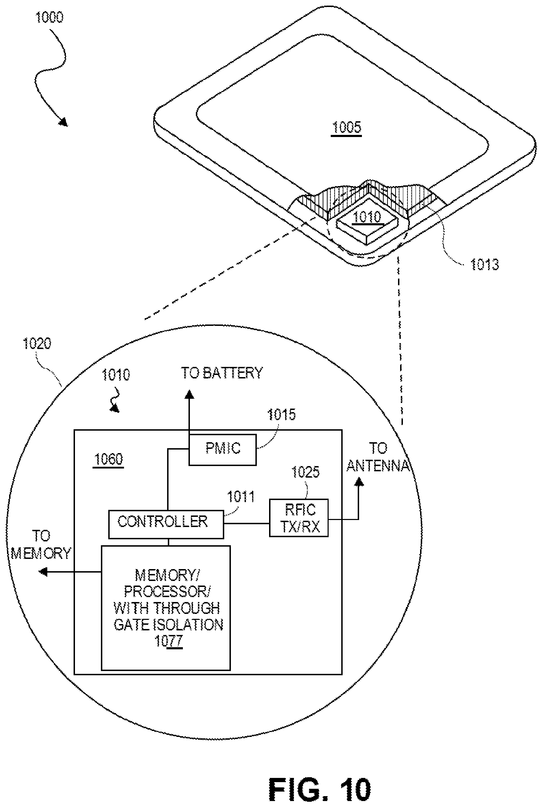

Figure 10 is an isometric view of a mobile computing platform 1000 employing an integrated circuit (IC) fabricated according to one or more processes described herein or including one or more features described herein, in accordance with an embodiment of the present disclosure.

The mobile computing platform 1000 may be any portable device configured for each of electronic data display, electronic data processing, and wireless electronic data transmission. For example, mobile computing platform 1000 may be any of a tablet, a smart phone, laptop computer, etc. and includes a display screen 1005 which in the exemplary embodiment is a touchscreen (capacitive, inductive, resistive, etc.), a chip-level (SoC) or package-level integrated system 1010, and a battery 1013. As illustrated, the greater the level of integration in the system 1010 enabled by higher transistor packing density, the greater the portion of the mobile computing platform 1000 that may be occupied by the battery 1013 or non-volatile storage, such as a solid state drive, or the greater the transistor gate count for improved platform functionality. Similarly, the greater the carrier mobility of each transistor in the system 1010, the greater the functionality. As such, techniques described herein may enable performance and form factor improvements in the mobile computing platform 1000.

The integrated system 1010 is further illustrated in the expanded view 1020. In the exemplary embodiment, packaged device 1077 includes at least one memory chip (e.g., RAM), or at least one processor chip (e.g., a multi-core microprocessor and/or graphics processor) fabricated according to one or more processes described herein or including one or more features described herein. The packaged device 1077 is further coupled to the board 1060 along with one or more of a power management integrated circuit (PMIC) 1015, RF (wireless) integrated circuit (RFIC) 1025 including a wideband RF (wireless) transmitter and/or receiver (e.g., including a digital baseband and an analog front end module further includes a power amplifier on a transmit path and a low noise amplifier on a receive path), and a controller thereof 1011. Functionally, the PMIC 1015 performs battery power regulation, DC-to-DC conversion, etc., and so has an input coupled to the battery 1013 and with an output providing a current supply to all the other functional modules. As further illustrated, in the exemplary embodiment, the RFIC 1025 has an output coupled to an antenna to provide to implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. In alternative implementations, each of these board-level modules may be integrated onto separate ICs coupled to the package substrate of the packaged device 1077 or within a single IC (SoC) coupled to the package substrate of the packaged device 1077.

In another aspect, semiconductor packages are used for protecting an integrated circuit (IC) chip or die, and also to provide the die with an electrical interface to external circuitry. With the increasing demand for smaller electronic devices, semiconductor packages are designed to be even more compact and must support larger circuit density. Furthermore, the demand for higher performance devices results in a need for an improved semiconductor package that enables a thin packaging profile and low overall warpage compatible with subsequent assembly processing.

In an embodiment, wire bonding to a ceramic or organic package substrate is used. In another embodiment, a C4 process is used to mount a die to a ceramic or organic package substrate. In particular, C4 solder ball connections can be implemented to provide flip chip interconnections between semiconductor devices and substrates. A flip chip or Controlled Collapse Chip Connection (C4) is a type of mounting used for semiconductor devices, such as integrated circuit (IC) chips, MEMS or components, which utilizes solder bumps instead of wire bonds. The solder bumps are deposited on the C4 pads, located on the top side of the substrate package. In order to mount the semiconductor device to the substrate, it is flipped over with the active side facing down on the mounting area. The solder bumps are used to connect the semiconductor device directly to the substrate.

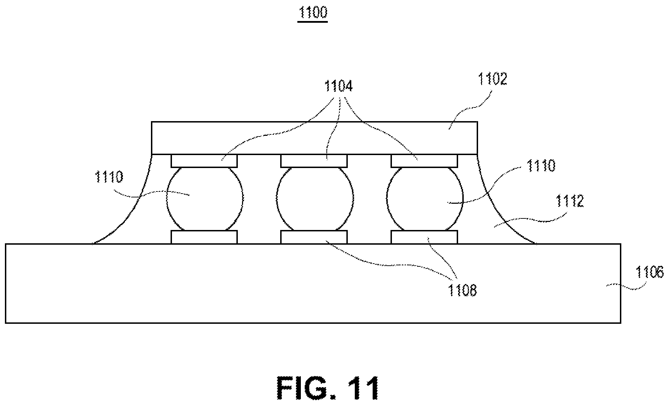

Figure 11 illustrates a cross-sectional view of a flip-chip mounted die, in accordance with an embodiment of the present disclosure.

Referring to Figure 11, an apparatus 1100 includes a die 1102 such as an integrated circuit (IC) fabricated according to one or more processes described herein or including one or more features described herein, in accordance with an embodiment of the present disclosure. The die 1102 includes metallized pads 1104 thereon. A package substrate 1106, such as a ceramic or organic substrate, includes connections 1108 thereon. The die 1102 and package substrate 1106 are electrically connected by solder balls 1110 coupled to the metallized pads 1104 and the connections 1108. An underfill material 1112 surrounds the solder balls 1110.

Processing a flip chip may be similar to conventional IC fabrication, with a few additional operations. Near the end of the manufacturing process, the attachment pads are metalized to make them more receptive to solder. This typically consists of several treatments. A small dot of solder is then deposited on each metalized pad. The chips are then cut out of the wafer as normal. To attach the flip chip into a circuit, the chip is inverted to bring the solder dots down onto connectors on the underlying electronics or circuit board. The solder is then re-melted to produce an electrical connection, typically using an ultrasonic or alternatively reflow solder process. This also leaves a small space between the chip's circuitry and the underlying mounting. In most cases an electrically-insulating adhesive is then "underfilled" to provide a stronger mechanical connection, provide a heat bridge, and to ensure the solder joints are not stressed due to differential heating of the chip and the rest of the system.

In other embodiments, newer packaging and die-to-die interconnect approaches, such as through silicon via (TSV) and silicon interposer, are implemented to fabricate high performance Multi-Chip Module (MCM) and System in Package (SiP) incorporating an integrated circuit (IC) fabricated according to one or more processes described herein or including one or more features described herein, in accordance with an embodiment of the present disclosure.

Thus, embodiments of the present disclosure include narrow conductive via structures for gate contact or trench contact, and methods of fabricating narrow conductive via structures for gate contact or trench contact.

Although specific embodiments have been described above, these embodiments are not intended to limit the scope of the present disclosure, even where only a single embodiment is described with respect to a particular feature. Examples of features provided in the disclosure are intended to be illustrative rather than restrictive unless stated otherwise. The above description is intended to cover such alternatives, modifications, and equivalents as would be apparent to a person skilled in the art having the benefit of the present disclosure.

The scope of the present disclosure includes any feature or combination of features disclosed herein (either explicitly or implicitly), or any generalization thereof, whether or not it mitigates any or all of the problems addressed herein. Accordingly, new claims may be formulated during prosecution of the present application (or an application claiming priority thereto) to any such combination of features. In particular, with reference to the appended claims, features from dependent claims may be combined with those of the independent claims and features from respective independent claims may be combined in any appropriate manner and not merely in the specific combinations enumerated in the appended claims.

The following examples pertain to further embodiments. The various features of the different embodiments may be variously combined with some features included and others excluded to suit a variety of different applications.

Example embodiment 1: An integrated circuit structure includes a plurality of gate structures above a substrate. A plurality of conductive trench contact structures is alternating with the plurality of gate structures. The integrated circuit structure also includes a plurality of dielectric spacers, a corresponding one of the plurality of dielectric spacers between adjacent ones of the plurality of gate structures and the plurality of conductive trench contact structures. The plurality of dielectric spacers protrudes above the plurality of gate structures and has an uppermost surface co-planar with an uppermost surface of the plurality of conductive trench contact structures. A dielectric liner is along the plurality of dielectric spacers over the plurality of gate structures. A plurality of conductive pin structures is between the dielectric liner, individual ones of the plurality of conductive pin structures on corresponding ones of the plurality of gate structures. The plurality of conductive pin structures have an uppermost surface co-planar with the uppermost surface of the plurality of conductive trench contact structures and co-planar with an uppermost surface of the dielectric liner.

Example embodiment 2: The integrated circuit structure of example embodiment 1, further including an interlayer dielectric material over the plurality of conductive trench contact structures, over the plurality of dielectric spacers, over the dielectric liner, and over the plurality of conductive pin structures; an opening in the interlayer dielectric material, the opening exposing one of the plurality of conductive pin structures; and a conductive via in the opening, the conductive via in direct contact with the one of the plurality of conductive pin structures.

Example embodiment 3: The integrated circuit structure of example embodiment 1 or 2, wherein the plurality of dielectric spacers have a different composition than the dielectric liner.

Example embodiment 4: The integrated circuit structure of example embodiment 1, 2 or 3, further including an interface between the plurality of dielectric spacers and the dielectric liner.

Example embodiment 5: The integrated circuit structure of example embodiment 1, 2, 3 or 4, further including an interface between the individual ones of the plurality of conductive pin structures and the corresponding ones of the plurality of gate structures.

Example embodiment 6: An integrated circuit structure includes a plurality of gate structures above a substrate. A plurality of conductive trench contact structures is alternating with the plurality of gate structures. The integrated circuit structure also includes a plurality of dielectric spacers, a corresponding one of the plurality of dielectric spacers between adjacent ones of the plurality of gate structures and the plurality of conductive trench contact structures. The plurality of dielectric spacers protrudes above the plurality of conductive trench contact structures and has an uppermost surface co-planar with an uppermost surface of the plurality of gate structures. A dielectric liner is along the plurality of dielectric spacers over the plurality of conductive trench contact structures. A plurality of conductive pin structures is between the dielectric liner, individual ones of the plurality of conductive pin structures on corresponding ones of the plurality of conductive trench contact structures. The plurality of conductive pin structures have an uppermost surface co-planar with the uppermost surface of the plurality of gate structures and co-planar with an uppermost surface of the dielectric liner.

Example embodiment 7: The integrated circuit structure of example embodiment 6, further including an interlayer dielectric material over the plurality of gate structures, over the plurality of dielectric spacers, over the dielectric liner, and over the plurality of conductive pin structures; an opening in the interlayer dielectric material, the opening exposing one of the plurality of conductive pin structures; and a conductive via in the opening, the conductive via in direct contact with the one of the plurality of conductive pin structures.

Example embodiment 8: The integrated circuit structure of example embodiment 6 or 7, wherein the plurality of dielectric spacers have a different composition than the dielectric liner.

Example embodiment 9: The integrated circuit structure of example embodiment 6, 7 or 8, further including an interface between the plurality of dielectric spacers and the dielectric liner.

Example embodiment 10: The integrated circuit structure of example embodiment 6, 7, 8 or 9, further including an interface between the individual ones of the plurality of conductive pin structures and the corresponding ones of the plurality of gate structures.

Example embodiment 11: A computing device includes a board, and a component coupled to the board. The component includes an integrated circuit structure including a plurality of gate structures above a substrate. A plurality of conductive trench contact structures is alternating with the plurality of gate structures. The integrated circuit structure also includes a plurality of dielectric spacers, a corresponding one of the plurality of dielectric spacers between adjacent ones of the plurality of gate structures and the plurality of conductive trench contact structures. The plurality of dielectric spacers protrudes above the plurality of gate structures and has an uppermost surface co-planar with an uppermost surface of the plurality of conductive trench contact structures. A dielectric liner is along the plurality of dielectric spacers over the plurality of gate structures. A plurality of conductive pin structures is between the dielectric liner, individual ones of the plurality of conductive pin structures on corresponding ones of the plurality of gate structures. The plurality of conductive pin structures have an uppermost surface co-planar with the uppermost surface of the plurality of conductive trench contact structures and co-planar with an uppermost surface of the dielectric liner.

Example embodiment 12: The computing device of example embodiment 11, further including a memory coupled to the board.

Example embodiment 13: The computing device of example embodiment 11 or 12, further including a communication chip coupled to the board.

Example embodiment 14: The computing device of example embodiment 11, 12 or 13, further including a camera coupled to the board.

Example embodiment 15: The computing device of example embodiment 11, 12, 13 or 14, wherein the component is a packaged integrated circuit die.

Example embodiment 16: A computing device includes a board, and a component coupled to the board. The component includes an integrated circuit structure including a plurality of gate structures above a substrate. A plurality of conductive trench contact structures is alternating with the plurality of gate structures. The integrated circuit structure also includes a plurality of dielectric spacers, a corresponding one of the plurality of dielectric spacers between adjacent ones of the plurality of gate structures and the plurality of conductive trench contact structures. The plurality of dielectric spacers protrudes above the plurality of conductive trench contact structures and has an uppermost surface co-planar with an uppermost surface of the plurality of gate structures. A dielectric liner is along the plurality of dielectric spacers over the plurality of conductive trench contact structures. A plurality of conductive pin structures is between the dielectric liner, individual ones of the plurality of conductive pin structures on corresponding ones of the plurality of conductive trench contact structures. The plurality of conductive pin structures have an uppermost surface co-planar with the uppermost surface of the plurality of gate structures and co-planar with an uppermost surface of the dielectric liner.

Example embodiment 17: The computing device of example embodiment 16, further including a memory coupled to the board.

Example embodiment 18: The computing device of example embodiment 16 or 17, further including a communication chip coupled to the board.

Example embodiment 19: The computing device of example embodiment 16, 17 or 18, further including a camera coupled to the board.

Example embodiment 20: The computing device of example embodiment 16, 17, 18 or 19, wherein the component is a packaged integrated circuit die.

## Claims

1. An integrated circuit structure, comprising:
a plurality of gate structures above a substrate;
a plurality of conductive trench contact structures alternating with the plurality of gate structures;
a plurality of dielectric spacers, a corresponding one of the plurality of dielectric spacers between adjacent ones of the plurality of gate structures and the plurality of conductive trench contact structures, wherein the plurality of dielectric spacers protrudes above the plurality of gate structures and has an uppermost surface co-planar with an uppermost surface of the plurality of conductive trench contact structures;
a dielectric liner along the plurality of dielectric spacers over the plurality of gate structures; and
a plurality of conductive pin structures between the dielectric liner, individual ones of the plurality of conductive pin structures on corresponding ones of the plurality of gate structures, the plurality of conductive pin structures having an uppermost surface co-planar with the uppermost surface of the plurality of conductive trench contact structures and co-planar with an uppermost surface of the dielectric liner.

2. The integrated circuit structure of claim 1, further comprising:
an interlayer dielectric material over the plurality of conductive trench contact structures, over the plurality of dielectric spacers, over the dielectric liner, and over the plurality of conductive pin structures;
an opening in the interlayer dielectric material, the opening exposing one of the plurality of conductive pin structures; and
a conductive via in the opening, the conductive via in direct contact with the one of the plurality of conductive pin structures.

3. The integrated circuit structure of claim 1 or 2, wherein the plurality of dielectric spacers have a different composition than the dielectric liner.

4. The integrated circuit structure of claim 1, 2 or 3, further comprising:
an interface between the plurality of dielectric spacers and the dielectric liner.

5. The integrated circuit structure of claim 1, 2, 3 or 4, further comprising:
an interface between the individual ones of the plurality of conductive pin structures and the corresponding ones of the plurality of gate structures.

6. A method of fabricating an integrated circuit structure, the method comprising:
forming a plurality of gate structures above a substrate;
forming a plurality of conductive trench contact structures alternating with the plurality of gate structures;
forming a plurality of dielectric spacers, a corresponding one of the plurality of dielectric spacers between adjacent ones of the plurality of gate structures and the plurality of conductive trench contact structures, wherein the plurality of dielectric spacers protrudes above the plurality of gate structures and has an uppermost surface co-planar with an uppermost surface of the plurality of conductive trench contact structures;
forming a dielectric liner along the plurality of dielectric spacers over the plurality of gate structures; and
forming a plurality of conductive pin structures between the dielectric liner, individual ones of the plurality of conductive pin structures on corresponding ones of the plurality of gate structures, the plurality of conductive pin structures having an uppermost surface co-planar with the uppermost surface of the plurality of conductive trench contact structures and co-planar with an uppermost surface of the dielectric liner.

7. The method of claim 6, further comprising:
forming an interlayer dielectric material over the plurality of conductive trench contact structures, over the plurality of dielectric spacers, over the dielectric liner, and over the plurality of conductive pin structures;
forming an opening in the interlayer dielectric material, the opening exposing one of the plurality of conductive pin structures; and
forming a conductive via in the opening, the conductive via in direct contact with the one of the plurality of conductive pin structures.

8. The method of claim 6 or 7, wherein the plurality of dielectric spacers have a different composition than the dielectric liner.

9. The method of claim 6, 7 or 8, further comprising:
forming an interface between the plurality of dielectric spacers and the dielectric liner.

10. The method of claim 6, 7, 8 or 9, further comprising:
forming an interface between the individual ones of the plurality of conductive pin structures and the corresponding ones of the plurality of gate structures.
